# FASCICULE DE BREVET EUROPEEN

(11) **EP 4 371 157 B1**
(45) Date de publication et mention de la délivrance du brevet: **30.04.2025**
(21) Numéro de dépôt: 22751026.0
(22) Date de dépôt: 12.07.2022
(51) Int. Cl.: H01L 25/075, H01L 25/16, H01L 21/683, H01L 23/00, H10H 29/39, H10H 29/20, H10H 20/825

(54) **DISPOSITIF D'AFFICHAGE INTERACTIF**
INTERAKTIVE ANZEIGEVORRICHTUNG
INTERACTIVE DISPLAY DEVICE

(30) Priorité: 16.07.2021 FR 2107693
(43) Date de publication de la demande: 22.05.2024
(73) Titulaire: Commissariat à l'Energie Atomique et aux Energies Alternatives, 75015 Paris (FR)
(72) Inventeur: TEMPLIER, François, 38054 GRENOBLE CEDEX 09 (FR); CASSET, Fabrice, 38054 GRENOBLE CEDEX 09 (FR); SEGURA PUCHADES, Josep, 38054 GRENOBLE CEDEX 09 (FR)
(74) Mandataire: Cabinet Beaumont
(86) Numéro de dépôt international: PCT/EP2022/069432
(87) Numéro de publication internationale: WO 2023/285449

(56) Documents cités:
- EP-B1- 3 381 060
- WO-A1-2019/235679
- GB-A- 2 156 153
- US-A1- 2004 018 796
- US-A1- 2014 077 686
- US-A1- 2019 157 492
- US-A1- 2019 313 954
- US-A1- 2020 126 475

## Description

La présente demande est basée sur, et revendique la priorité de, la demande de brevet français FR2107693 déposée le 16 juillet 2021 et avant pour titre « Dispositif d'affichage interactif et procédé de fabrication d'un tel dispositif >>.

### Domaine technique

La présente description concerne de façon générale le domaine des dispositifs d'affichage d'images, et vise plus particulièrement un dispositif d'affichage d'images interactif, combinant une fonction d'émission lumineuse et une fonction de capture optique, et un procédé de fabrication d'un tel dispositif. Plus généralement, elle concerne un dispositif d'affichage d'images combinant une fonction d'émission lumineuse et une fonction de capture ou d'actuation.

### Technique antérieure

Il a déjà été proposé, par exemple dans les demandes de brevet WO2017089676, EP3401958 et WO2018185433 précédemment déposées par le demandeur, des dispositifs d'affichage d'images comportant une pluralité de puces électroniques monolithiques élémentaires disposées en matrice sur un même substrat de report. Les puces élémentaires sont montées solidaires du substrat de report et connectées à des éléments de connexion électrique du substrat de report pour leur commande. Chaque puce comporte une ou plusieurs diodes électroluminescents (LED) et un circuit de commande de ladite une ou plusieurs LED et correspond à un pixel du dispositif. Le circuit de commande comprend une face de connexion opposée à ladite une ou plusieurs LED, comprenant une pluralité de plages de connexion électrique destinées à être connectées au substrat de report pour la commande de la micropuce. Le substrat de report comprend une face de connexion comportant, pour chaque micropuce, une pluralité de plages de connexion électrique destinées à être connectées respectivement aux plages de connexion électrique de la micropuce. Les puces sont rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Ce type de dispositif d'affichage est particulièrement adapté pour réaliser des écrans d'affichage de grande surface, par exemple des écrans d'ordinateur, de téléviseur, de tablette, etc.

On s'intéresse ici plus particulièrement à la réalisation d'un dispositif d'affichage d'images interactif combinant une fonction d'émission lumineuse et une fonction de capture optique. Plus généralement, on s'intéresse ici à la réalisation d'un dispositif d'affichage d'images interactif combinant une fonction d'émission lumineuse et une fonction de capture ou d'actuation.

Le document US 2019/157492 A1 divulgue un dispositif optique comprenant un détecteur fixé dans une région d'un substrat, et comportant un contact électrique exposé à partir d'une surface du substrat, ainsi qu'une couche de circuit fixée sur la surface du substrat et connectée électriquement à un contact électrique du détecteur.

### Résumé de l'invention

Selon l'invention, un dispositif tel que décrit dans la revendication 1 est divulgué.

Selon un mode de réalisation, chaque élément de capture et d'actuation est un photodétecteur.

Selon un mode de réalisation, chaque photodétecteur comprend une couche organique photosensible.

Selon un mode de réalisation, dans chaque puce élémentaire, le circuit électronique de commande de la LED et le circuit électronique de lecture ou de commande de l'élément de capture ou d'actuation comprennent des transistors MOS formés dans et sur une couche de silicium monocristallin.

Selon un mode de réalisation, dans chaque puce élémentaire, la LED est une LED inorganique.

Selon un mode de réalisation, dans chaque puce élémentaire, la LED est une LED au nitrure de gallium.

Selon un mode de réalisation, chaque puce élémentaire comprend une pluralité de sous-pixels comprenant chacun une LED et un circuit de commande de la LED.

Selon un mode de réalisation, dans chaque puce élémentaire, les circuits de commande des LED des différents sous-pixels de la puce sont connectés à une même borne d'entrée de la puce, connectée à une plage de connexion correspondante du substrat de report, destinée à recevoir séquentiellement des signaux de consigne d'émission des différents sous-pixels de la puce.

Selon un mode de réalisation, dans chaque puce élémentaire, les circuits de commande des LED des différents sous-pixels de la puce sont connectés respectivement à différentes bornes d'entrée de la puce, connectées respectivement à différentes plages de connexion correspondantes du substrat de report, destinées à recevoir en parallèle des signaux de consigne d'émission des différents sous-pixels de la puce.

Selon un mode de réalisation, dans chaque puce élémentaire, le circuit de commande de la LED est configuré pour commander la LED au moyen de signaux de consigne numériques à codage binaire.

Selon un mode de réalisation, dans chaque puce élémentaire, le circuit de lecture du photodétecteur associé à la puce est connecté à une borne de sortie de la puce, connectée à une plage de connexion correspondante du substrat de report, destinée à fournir un signal représentatif d'une intensité lumineuse reçue par le photodétecteur.

Selon un mode de réalisation, l'élément de capture ou d'actuation est un transducteur piézoélectrique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A, 1B, 1C, 1D, 1E, 1F, 1G, 1H, 1I et 1J sont des vues en coupe illustrant des étapes successives d'un exemple d'un procédé de fabrication de puces élémentaires de pixel d'un dispositif d'affichage interactif selon un mode de réalisation ;
la figure 2 est une vue de dessus illustrant de façon schématique et partielle un exemple d'un substrat de report d'un dispositif d'affichage interactif selon un mode de réalisation ;
les figures 3A, 3B, 3C, 3D et 3E sont des vues en coupe illustrant des étapes successives d'un exemple d'un procédé de fabrication d'un dispositif d'affichage interactif selon un mode de réalisation ;
la figure 4 est un schéma électrique des circuits d'un exemple d'une puce élémentaire de pixel d'un dispositif d'affichage interactif selon un mode de réalisation ;
la figure 5 est un diagramme illustrant de façon schématique le fonctionnement de la puce élémentaire de pixel de la figure 4 ;
la figure 6 est un schéma électrique des circuits d'un autre exemple d'une puce élémentaire de pixel d'un dispositif d'affichage interactif selon un mode de réalisation ; et
la figure 7 est un diagramme illustrant de façon schématique le fonctionnement de la puce élémentaire de pixel de la figure 6.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses applications que peuvent avoir les dispositifs d'affichage interactifs décrits n'ont pas été détaillées, les modes de réalisation décrits étant compatibles avec toutes ou la plupart des applications connues d'un dispositif d'affichage émissif intégrant une fonction de capture optique, par exemple des applications de détection de mouvement, de reconnaissance de visage, d'identification, etc, et plus généralement, d'un dispositif d'affichage émissif intégrant une fonction de capture ou d'actuation.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures correspondantes.

Sauf précision contraire, les expressions "environ", "approximativement", "sensiblement", et "de l'ordre de" signifient à 10 % près, de préférence à 5 % près.

Selon un aspect d'un mode de réalisation, on prévoit un dispositif d'affichage d'images comportant une pluralité de puces électroniques monolithiques élémentaires disposées en matrice sur un même substrat de report. Comme dans les exemples décrits dans les demandes de brevet WO2017089676, EP3401958 et WO2018185433 précédemment déposées par le demandeur, les puces élémentaires sont montées solidaires du substrat de report et connectées à des éléments de connexion électrique du substrat de report. Chaque puce comporte une ou plusieurs LED et un circuit de commande de ladite une ou plusieurs LED et correspond à un pixel du dispositif. Le circuit de commande comprend une face de connexion opposée à ladite une ou plusieurs LED, comprenant une pluralité de plages (aussi appelées bornes ou plots) de connexion électrique destinées à être connectées au substrat de report pour la commande de la micropuce. Le substrat de report comprend une face de connexion comportant, pour chaque micropuce, une pluralité de plages (aussi appelées bornes ou plots) de connexion électrique destinées à être connectées respectivement aux plages de connexion électrique de la micropuce. Les puces sont rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Selon un aspect d'un mode de réalisation, le dispositif d'affichage d'images comprend en outre une fonction de capture optique, par exemple une fonction de capture d'images. Pour cela, le dispositif comprend une pluralité de photodétecteurs, par exemple des photodétecteurs organiques, agencés en matrice selon des rangées et des colonnes et définissant un capteur d'images. Les photodétecteurs sont externes aux puces élémentaires de pixel du dispositif d'affichage, et sont disposés sur le substrat de report du dispositif, du même côté du substrat de report que les puces élémentaires de pixel. Les photodétecteurs sont connectés à des bornes de connexion électrique du substrat de report pour leur lecture.

A titre d'exemple, le dispositif comprend un photodétecteur par puce élémentaire de pixel du dispositif, disposé au voisinage de ladite puce élémentaire de pixel. Autrement dit, la matrice de puces élémentaires de pixel du dispositif d'affichage et la matrice de photodétecteurs sont des matrices entrelacées de mêmes dimensions et de même pas.

Selon un aspect d'un mode de réalisation, chaque puce élémentaire de pixel du dispositif d'affichage intègre un circuit électronique de lecture d'un signal électrique représentatif d'une intensité lumineuse reçue par le photodétecteur correspondant, c'est-à-dire de même position dans la matrice de pixels, du dispositif. Chaque puce élémentaire de pixel du dispositif comprend pour cela une borne de connexion connectée individuellement à une électrode du photodétecteur associé par l'intermédiaire d'une piste conductrice du substrat de report.

Des exemples de réalisation d'un tel dispositif d'affichage interactif vont être décrits plus en détail ci-après en relation avec les figures.

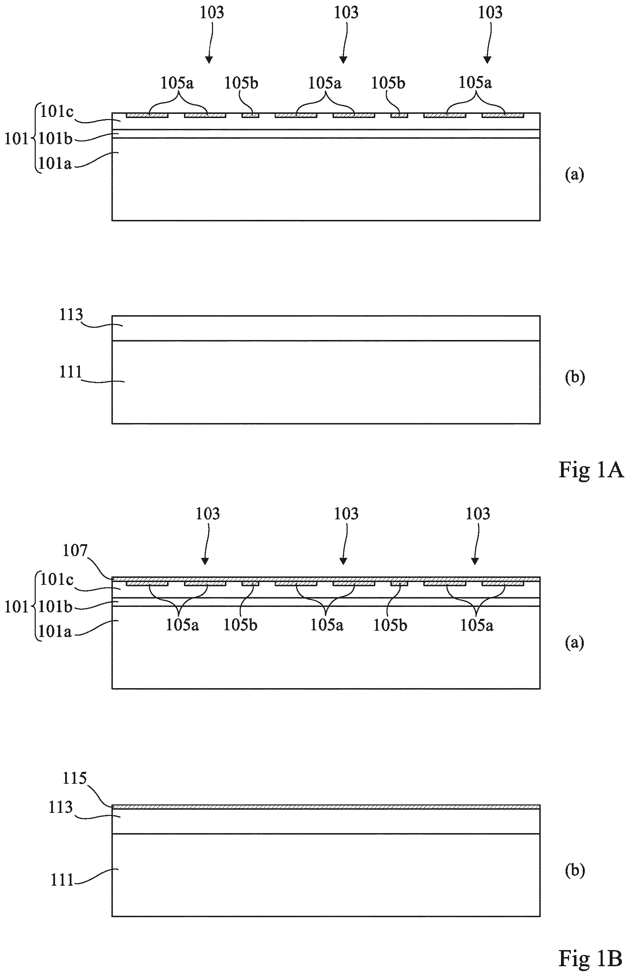

Les figures 1A à 1J sont des vues en coupe illustrant un exemple d'un procédé de fabrication des puces élémentaires de pixel du dispositif.

La figure 1A comprend une vue (a) représentant de façon schématique une structure de contrôle comprenant un premier substrat 101 dans et sur lequel ont été formés une pluralité de circuits intégrés élémentaires de contrôle 103, par exemple identiques ou similaires, correspondant respectivement aux circuits intégrés de contrôle des futures puces élémentaires de pixel du dispositif.

Dans l'exemple représenté, le substrat 101 est un substrat de type SOI (de l'anglais "Semiconductor On Insulator" - semiconducteur sur isolant), comportant un substrat semiconducteur de support 101a, par exemple en silicium, une couche isolante 101b, par exemple en oxyde de silicium, disposée sur et en contact avec la face supérieure du substrat de support 101a, et une couche semiconductrice supérieure 101c, par exemple en silicium monocristallin, disposée sur et en contact avec la face supérieure de la couche isolante 101b.

Dans cet exemple, les circuits élémentaires de contrôle 103 sont formés dans et sur la couche semiconductrice supérieure 101c du substrat 101. Chaque circuit élémentaire de contrôle 103 comprend par exemple une pluralité de transistors (non détaillés sur les figures 1A à 1I), par exemple des transistors MOS, par exemple intégrés dans et sur une couche de silicium monocristallin. Les circuits élémentaires de contrôle 103 sont par exemple réalisés en technologie CMOS (de l'anglais "Complementary Metal Oxyde Semiconductor" - métal oxyde semiconducteur complémentaire). Chaque circuit élémentaire de contrôle 103 peut comprendre un circuit adapté à contrôler l'émission de lumière par la ou les LED de la future puce élémentaire de pixel du dispositif, et un circuit de lecture du photodétecteur associé à la future puce élémentaire de pixel du dispositif.

Dans cet exemple, chaque circuit élémentaire de contrôle 103 comprend, du côté de sa face supérieure, un ou plusieurs plots de connexion métalliques 105a, 105b. A titre d'exemple, les plots 105a, 105b affleurent du côté de la face supérieure d'une couche isolante supérieure, par exemple en oxyde de silicium, d'un empilement d'interconnexion (non détaillé sur les figures) revêtant la face supérieure de la couche semiconductrice supérieure 103c du substrat 101. Ainsi, dans cet exemple, la surface supérieure de la structure de contrôle de la vue (a) est une surface plane comportant une alternance de régions métalliques (les plots 105a, 105b) et de régions isolantes.

A titre d'exemple, chaque circuit élémentaire de contrôle 103 comprend un plot métallique 105a spécifique pour chaque LED de la future puce élémentaire de pixel du dispositif, destiné à être connecté à une région d'anode de la LED et permettant de commander individuellement l'émission de lumière par ladite LED. Chaque circuit élémentaire de contrôle 103 peut en outre comprendre un plot métallique 105b destiné à être connecté à une région de cathode de chaque LED de la future puce élémentaire de pixel du dispositif. Dans le cas où la puce élémentaire comporte plusieurs LED, le contact de cathode peut être commun à toutes les LED de la puce. Ainsi, le circuit élémentaire de contrôle 103 peut comprendre un unique plot métallique 105b.

A titre d'exemple, chaque puce élémentaire de pixel du dispositif comprend trois LED commandables individuellement adaptées à émettre respectivement de la lumière bleue, de la lumière verte et de la lumière rouge. Dans ce cas, chaque circuit élémentaire de contrôle 103 peut comprendre trois plots métalliques 105a distincts destinés à être connectés respectivement aux régions d'anode des trois LED, et un unique plot métallique 105b destiné à être connecté collectivement aux régions de cathode des trois LED. Sur la figure 1A, seuls deux plots métalliques 105a et un plot métallique 105b par circuit électronique ont été représentés.

La figure 1A comprend en outre une vue (b) représentant de façon très schématique une structure comprenant un deuxième substrat 111, sur la face supérieure duquel repose un empilement actif de LED 113. L'empilement actif de LED 113 est par exemple un empilement de LED inorganique, par exemple à base d'un ou plusieurs matériaux semiconducteurs de type III-V, par exemple à base de nitrure de gallium. Le substrat 111 est par exemple en saphir ou en silicium.

L'empilement actif de LED 113 comprend par exemple, dans l'ordre en partant de la face supérieure du substrat 111, une couche semiconductrice dopée de type N formant une couche de cathode, une couche active, et une couche semiconductrice dopée de type P formant une couche d'anode (couches non détaillées sur la figure). La couche active comporte par exemple une alternance de couches de puits quantiques en un premier matériau semiconducteur et de couches barrières en un deuxième matériau semiconducteur définissant un empilement de puits quantiques multiples.

L'empilement actif 113 peut être formé par épitaxie sur la face supérieure du substrat 111. A titre de variante, l'empilement actif 113 est formé par épitaxie sur un substrat de croissance, non représenté, puis reporté sur la face supérieure du substrat 111.

A ce stade, l'empilement 113 n'est pas encore structuré en LED individuelles. Autrement dit, les couches de l'empilement 113 s'étendent chacune de façon continue et avec une épaisseur sensiblement uniforme sur toute la surface supérieure du substrat 111.

La figure 1B comprend une vue (a) illustrant une étape de dépôt d'une couche métallique 107 sur et en contact avec la face supérieure de la structure de contrôle de la vue (a) de la figure 1A. Dans cet exemple, la couche 107 s'étend de façon continue et avec une épaisseur sensiblement uniforme sur toute la surface supérieure de l'empilement d'interconnexion de la structure de contrôle de la vue (a) de la figure 1A. Ainsi, la couche 107 connecte les uns aux autres tous les plots métalliques 105a, 105b de la structure de contrôle.

La figure 1B comprend en outre une vue (b) illustrant une étape de dépôt d'une couche métallique 115 sur et en contact avec la face supérieure de l'empilement actif de LED 113 de la structure de la vue (b) de la figure 1A. La couche métallique 115 peut être une couche unique ou un empilement de plusieurs couches métalliques. De préférence, la couche métallique 115 comprend, du côté de sa face supérieure, une couche en le même matériau que la couche 107.

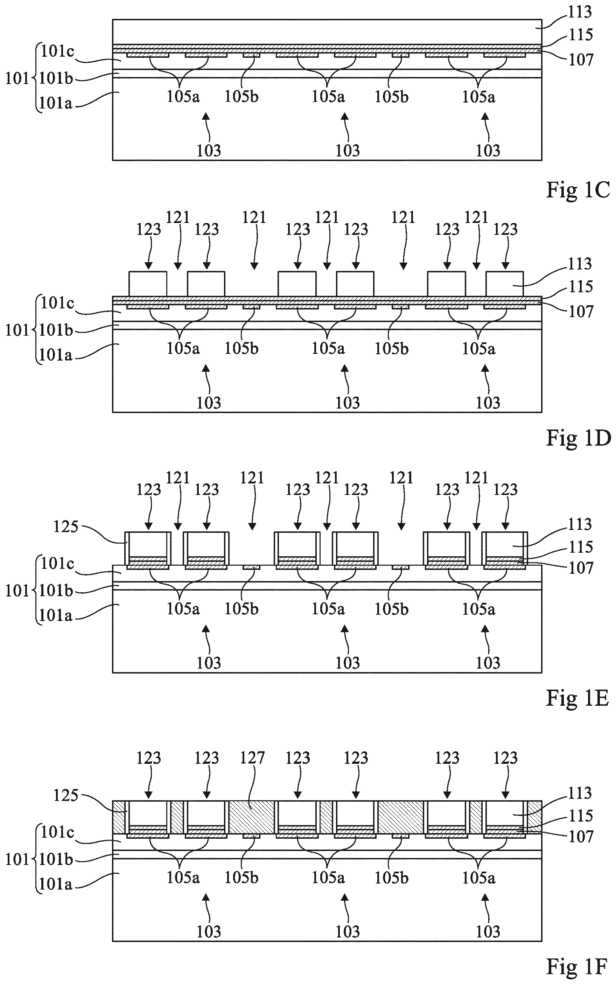

La figure 1C illustre la structure obtenue à l'issue d'une étape de report et de fixation de l'empilement actif de LED 113 et de la couche métallique 115 sur la structure de la vue (a) de la figure 1B.

Sur la figure 1C, l'orientation de la structure de la vue (a) de la figure 1B reste inchangée. En revanche, les éléments de la structure de vue (b) de la figure 1B sont inversés par rapport à l'orientation de la figure 1B.

Lors de cette étape, la structure de la vue (b) de la figure 1B est rapportée sur la face supérieure de la structure de la vue (a) de la figure 1B, en utilisant le substrat 111 comme poignée. La face inférieure (dans l'orientation de la figure 1C, correspondant à la face supérieure dans l'orientation de la figure 1B) de la couche métallique 115 est fixée sur la face supérieure de la couche métallique 107. La fixation est par exemple obtenue par collage direct ou collage moléculaire de la face inférieure de la couche 115 sur la face supérieure de la couche 107, c'est-à-dire sans apport de matière entre les deux couches.

Le substrat 111 est ensuite retiré, par exemple par meulage et/ou gravure chimique, de façon à libérer l'accès à la face supérieure de l'empilement actif de LED 113, c'est-à-dire, dans cet exemple, la face supérieure de la couche semiconductrice de cathode de l'empilement actif de LED 113.

La figure 1D illustre une étape de formation de tranchées 121 s'étendant verticalement dans l'empilement actif de LED depuis sa face supérieure et délimitant latéralement, dans l'empilement 113, une pluralité d'ilots 123 correspondant aux LED individuelles des futures puces élémentaires du dispositif. Les tranchées 121 sont par exemple formées par gravure plasma. Dans l'exemple de la figure 1D, les tranchées 121 s'interrompent sur la face supérieure de la couche métallique 115. En vue de dessus (non représentée), les tranchées 121 forment une grille séparant latéralement les diodes élémentaires 123 les unes des autres.

La figure 1E illustre une étape ultérieure de prolongement vertical des tranchées 121 à travers les couches métalliques 107 et 115, par exemple en utilisant le même masque de gravure (non représenté) que celui utilisé à l'étape précédente. A l'issue de cette étape, les tranchées 121 débouchent sur la face supérieure de l'empilement d'interconnexion revêtant la face supérieure du substrat 101.

La portion de l'empilement des couches 107 et 115 subsistant sous chaque LED 123 à l'issue de cette étape constitue une électrode d'anode de la LED. Ladite électrode d'anode est en contact, par sa face inférieure, avec la face supérieure d'un plot métallique de connexion 105a du circuit élémentaire de contrôle 103 sous-jacent. Ainsi, chaque LED a son électrode d'anode connectée individuellement à un plot métallique de connexion 105a d'un circuit élémentaire de contrôle 103.

Dans cet exemple, une tranchée 121 est en outre formée en vis-à-vis de chaque plot métallique de connexion 105b de façon à libérer l'accès à la face supérieure des plots 105b.

La figure 1E illustre en outre une étape ultérieure de passivation des flancs des LED 123. Pour cela, une couche 125 en un matériau électriquement isolant, par exemple de l'oxyde de silicium ou du nitrure de silicium, est déposée par une méthode de dépôt conforme sur la face supérieure de la structure. La couche 125 revêt alors la face supérieure et les flancs des LED 123, ainsi que les flancs des portions des couches métalliques 107 et 115 situées sous les LED 123, et, au fond des tranchées 121, la face supérieure de l'empilement d'interconnexion revêtant le substrat 101. Une étape de gravure anisotrope verticale est ensuite mise en oeuvre pour retirer les portions horizontales de la couche 125, et conserver uniquement les portions verticales de cette couche, revêtant les flancs des LED 123 et les flancs des portions des couches métalliques 107 et 115 situées sous les LED 123.

La figure 1F illustre une étape ultérieure de remplissage des tranchées 121 par du métal 127. A titre d'exemple, le métal 127 est initialement déposé sur toute la surface supérieure de la structure avec une épaisseur supérieure à la profondeur des tranchées 121, de façon à combler entièrement les tranchées 121. Une étape de planarisation, par exemple par polissage mécano-chimique, est ensuite mise en oeuvre pour libérer l'accès à la face supérieure des LED 123. On obtient ainsi une surface supérieure sensiblement plane sur laquelle affleurent les régions semiconductrices de cathode des LED 123, les régions verticales d'isolation 125 des LED, et les régions métalliques 127 remplissant les tranchées 121. En vue de dessus (non représentée), les régions métalliques 127 forment une grille conductrice séparant latéralement les LED 123 les unes des autres. Les régions métalliques 127 sont connectées électriquement aux plots métalliques 105b au fond des tranchées 121, et définissent une métallisation de contact de cathode commune à l'ensemble des LED 123 de la structure.

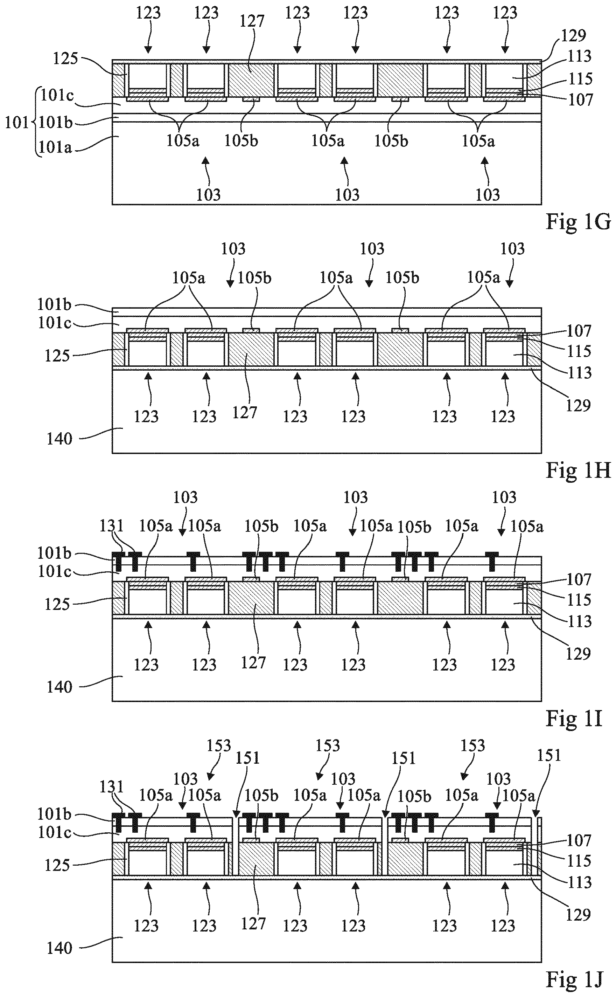

La figure 1G illustre une étape ultérieure de dépôt d'une couche conductrice 129, transparente aux longueurs d'onde d'émission des LED du dispositif d'affichage, sur la face supérieure de la structure. La couche 129 s'étend par exemple de façon continue et avec une épaisseur sensiblement uniforme sur toute la surface supérieure de la structure de la figure 1F. La couche 129 est par exemple en un oxyde conducteur transparent, par exemple en oxyde d'indium-étain (ITO). A titre de variante, la couche 129 peut être une couche métallique suffisamment mince pour être transparente, par exemple une couche d'argent d'épaisseur inférieure à 80 nm.

La couche 129 est en contact, par sa face inférieure, avec la face supérieure des régions semiconductrices de cathode des LED 123, et définit une électrode commune de cathode des LED 123. La couche 129 est en outre en contact, par sa face inférieure, avec la face supérieure de la région métallique 127. Ainsi, la couche 129 connecte électriquement la région semiconductrice de cathode de chaque LED 123 à la métallisation de contact de cathode commune 127 de la structure.

La figure 1H illustre une étape ultérieure de report de la structure de la figure 1G sur un substrat de support temporaire 140. Sur la figure 1H, l'orientation de la structure est inversée par rapport à l'orientation de la figure 1G. Le substrat de support temporaire est fixé sur la face de la couche conductrice 129 opposée au substrat 101, c'est-à-dire sa face inférieure dans l'orientation de la figure 1H (correspondant à sa face supérieure dans l'orientation de la figure 1G). Le substrat de support temporaire 140 est par exemple un substrat en silicium. La fixation du substrat de support temporaire 140 sur la couche conductrice 129 peut être obtenue au moyen d'une couche adhésive de collage, ou par collage direct.

La figure 1H illustre en outre une étape ultérieure de retrait du substrat de support 101a de la structure SOI de départ, par exemple par meulage et/ou gravure chimique, de façon à libérer l'accès à la face supérieure de la couche isolante 101b de la structure SOI.

On notera que les modes de réalisation décrits ne se limitent pas à l'exemple décrit ci-dessus dans lequel le substrat 101 est un substrat de type SOI. A titre de variante, le substrat 101 peut être un substrat semiconducteur massif, par exemple en silicium. Dans ce cas, à l'étape de la figure 1A, le substrat 101 peut être aminci par sa face arrière (face supérieure dans l'orientation de la figure 1H), par exemple par meulage. Une couche isolante de passivation, par exemple en oxyde de silicium, peut ensuite être déposée sur la face supérieure du substrat aminci, remplaçant la couche 101b du substrat SOI. A titre de variante, la couche 101b peut être omise.

La figure 1I illustre la structure obtenue à l'issue d'étapes de formation d'ouvertures de reprise de contact dans les couches 101b et 101c, et de formation de métallisations de reprise de contact 131 dans et sur lesdites ouvertures. Les métallisations de contact 131 permettent de reprendre des contacts électriques sur des niveaux métalliques (non détaillés sur les figures) de l'empilement d'interconnexion disposé du côté de la face inférieure de la couche semiconductrice 101c. Les métallisations 131 sont par exemple connectées électriquement à des transistors du circuit de contrôle, ces transistors étant eux-mêmes connectés ou reliés électriquement à des métallisations de connexion 105a, 105b des LED.

Les métallisations 131 forment des bornes de connexion des futures puces élémentaires de pixel du dispositif, destinées à être connectées à des bornes de connexion correspondantes du substrat de report du dispositif.

La figure 1J illustre la structure obtenue à l'issue d'une étape de singularisation des puces élémentaires de pixel du dispositif. Pour cela, des tranchées 151 s'étendant verticalement à travers les couches 101b, 101c, 127 et 129 sont formées à partir de la face supérieure de la structure, selon des lignes de découpe. Dans cet exemple, les tranchées débouchent sur la face supérieure du substrat de support temporaire 140. En vue de dessus, les tranchées 151 forment une grille continue délimitant latéralement une pluralité de puces élémentaires de pixel 153, par exemple identiques ou similaires, comportant chacune un circuit de contrôle élémentaire 103 et une ou plusieurs LED 123. Les tranchées 151 sont par exemple réalisées par gravure plasma.

On notera que dans l'exemple décrit en relation avec les figures 1A à 1J, les LED élémentaires 123 sont formées à partir d'un même empilement actif de LED et émettent toutes à la même longueur d'onde. Dans le cas où les puces élémentaires 153 comprennent chacune plusieurs LED 123, des étapes de formation d'éléments de conversion lumineuse différentiés sur les différentes LED 123 de chaque puce peuvent être prévues, par exemple après le dépôt de la couche conductrice de cathode 129 et avant la fixation du substrat de support temporaire 140. Par souci de simplification, la réalisation des éléments de conversion n'a pas été détaillée sur les figures. La réalisation de ces éléments est à la portée de la personne du métier à la lecture de la présente description. A titre de variante, chaque puce élémentaire peut comprendre des LED 123 de natures distinctes adaptées à émettre respectivement dans des gammes de longueurs d'ondes distinctes, auquel cas les éléments de conversion peuvent être omis.

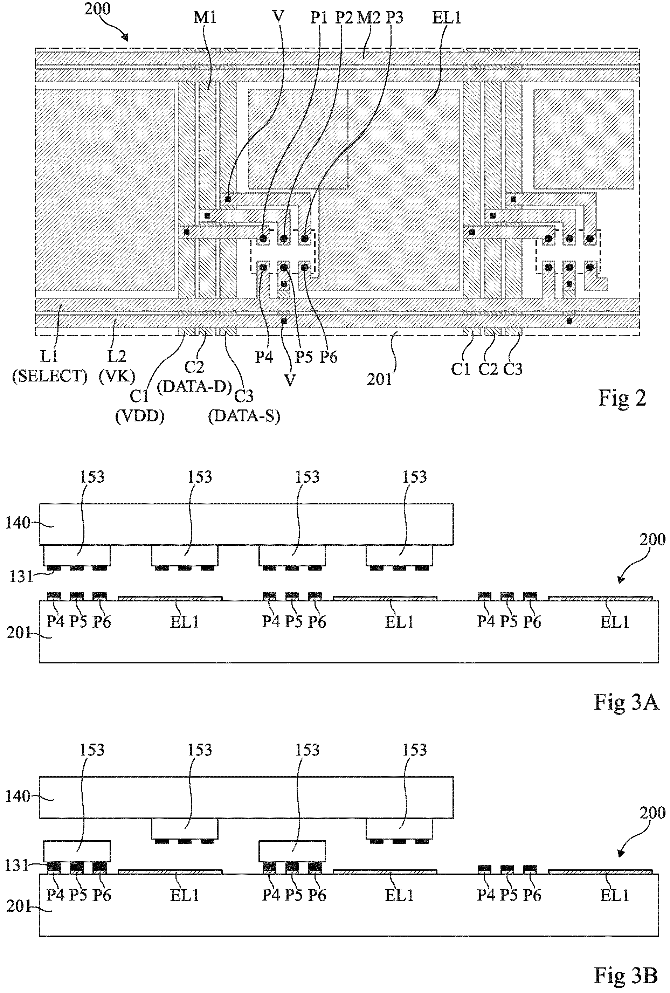

Les puces élémentaires de pixel 153 sont destinées à être reportées sur un substrat de report 200 du dispositif d'affichage, comme cela sera décrit plus en détail ci-après en relation avec les figures 3A à 3E.

La figure 2 est une vue de dessus schématique et partielle d'un exemple de réalisation du substrat de report 200 du dispositif d'affichage.

Sur la figure 2, seule une portion du substrat de report, correspondant à deux pixels adjacents d'une même ligne du dispositif d'affichage, a été représentée.

Le substrat de report 200 comprend par exemple une plaque ou feuille de support 201 en un matériau isolant, par exemple en verre ou en plastique. A titre de variante, la plaque ou feuille de support 201 comprend un support conducteur, par exemple métallique, recouvert par une couche d'un matériau isolant. Le substrat de report comprend en outre des éléments de connexion électrique, et en particulier des pistes conductrices et des plages conductrices, formés sur la face supérieure de la plaque de support 201. Ces éléments de connexion électrique sont par exemple formés par impression d'une succession de niveaux conducteurs et isolants sur la face supérieure de la plaque de support 201. Les éléments de connexion électrique sont par exemple formés par un procédé de dépôt ou d'impression de type impression jet d'encre, par sérigraphie, par rotogravure, par dépôt sous vide, ou par toute autre méthode adaptée.

Dans l'exemple représenté, le substrat de report 201 comprend deux niveaux métalliques conducteurs M1 et M2 séparés par un niveau isolant (non visible sur la figure), et des vias métalliques V connectant les deux niveaux métalliques à travers le niveau isolant. Dans cet exemple, le substrat de report 201 comprend en outre des plages métalliques de connexion formées sur le niveau métallique supérieure M2, destinées à être connectées à des plages de connexion 131 correspondantes des puces élémentaires de pixel 153 du dispositif.

Des circuits actifs de commande du dispositif d'affichage, adaptés à alimenter et commander les puces élémentaires du dispositif par l'intermédiaire des éléments de connexion électrique du substrat de report, sont par exemple connectés aux éléments de connexion électrique du substrat de report à la périphérie du substrat de report 200.

Dans l'exemple représenté, la fabrication du substrat de report comprend les trois étapes successives de dépôt suivantes.

Lors d'une première étape de dépôt, on forme sur la face supérieure de la plaque de support 210 une pluralité de pistes conductrices sensiblement parallèles à la direction des colonnes du dispositif d'affichage (direction verticale dans l'orientation de la figure 2). Plus particulièrement, dans cet exemple, lors de la première étape de dépôt, on forme, pour chaque colonne du dispositif d'affichage, trois pistes conductrices C1, C2 et C3 s'étendant sur sensiblement toute la longueur des colonnes du dispositif d'affichage. Les pistes C1 sont destinées à distribuer un potentiel d'alimentation haut VDD aux différentes puces élémentaires de pixel 153. Les pistes C2 sont destinées à véhiculer un signal DATA_D de réglage de l'intensité lumineuse émise par les LED 123 des puces élémentaires 153 de la colonne. Les pistes C3 sont destinées à véhiculer un signal DATA_S représentatif de l'intensité lumineuse reçue par les photodétecteurs des pixels de la colonne.

Les éléments conducteurs formés lors de cette première étape de dépôt définissent le premier niveau conducteur M1 du substrat de report.

Lors d'une deuxième étape de dépôt, on recouvre le premier conducteur d'un matériau isolant (non visible sur la figure), de façon à permettre le dépôt ultérieur de pistes conductrices s'étendant au-dessus des pistes C1, C2 et C3, sans créer de court-circuit avec les pistes C1, C2 et C3.

Lors d'une troisième étape de dépôt, on forme sur la face supérieure de la plaque de support 201 une pluralité de pistes conductrices sensiblement parallèles à la direction des lignes du dispositif d'affichage. Plus particulièrement, dans cet exemple, lors de la troisième étape de dépôt, on imprime, pour chaque ligne du dispositif d'affichage, deux pistes conductrices L1 et L2 s'étendant sur sensiblement toute la longueur des lignes du dispositif d'affichage. Les pistes L1 sont destinées à véhiculer un signal SELECT de sélection de la ligne de pixel correspondante. Les pistes L2 sont destinées à distribuer un potentiel d'alimentation bas VK, par exemple inférieur au potentiel VDD, aux différentes puces élémentaires de pixel 153.

Dans cet exemple, lors de la troisième étape de dépôt, est en outre imprimée, pour chaque pixel du dispositif, une région métallique EL1 définissant une électrode inférieure du photodétecteur du dispositif d'affichage.

Les éléments conducteurs imprimés lors de cette troisième étape de dépôt définissent le deuxième niveau conducteur M2 du substrat de report.

Après la troisième étape de dépôt, on vient former, pour chaque pixel, sur des zones conductrices du niveau métallique M2, six plages métalliques P1, P2, P3, P4, P5 et P6 destinées à recevoir respectivement six plages de connexion 131 distinctes de la puce élémentaire 153 du pixel. Les plages P1, P2, P3, P4, P5 et P6 sont connectées respectivement aux pistes conductrices C1, C2, C3, L1, L2 et à l'électrode EL1 du pixel, par des éléments conducteurs formés dans le niveau métallique M2, et, éventuellement, par des vias V (ouverts entre les deuxième et troisième étapes de dépôt) et des éléments conducteurs formés dans le niveau métallique M1.

Les figures 3A à 3E sont des vues en coupe illustrant des étapes successives d'un exemple d'un procédé de fabrication d'un dispositif d'affichage interactif selon un mode de réalisation.

Les figures 3A et 3B illustrent plus particulièrement une étape de transfert collectif de puces élémentaires de pixel 153 sur le substrat de report 200.

Les puces élémentaires 153 sont initialement fixées à une face du substrat de support temporaire 140. La structure comportant le substrat de support temporaire 140 et les puces élémentaires 153 est par exemple réalisée par un procédé du type décrit en relation avec les figures 1A à 1J. Dans l'exemple représenté, la structure est retournée par rapport à l'orientation de la figure 1J, c'est-à-dire que les puces élémentaires 153 sont disposées du côté de la face inférieure du substrat de support temporaire 140.

Par souci de simplification, sur les figures 3A à 3J, les puces élémentaires 153 et le substrat de report 200 ont été représentés de façon schématique, et de nombreux éléments ont été omis par rapport aux représentations des figures 1J et 2.

Les puces élémentaires 153 sont rapportées collectivement en vis-à-vis de la face de connexion du substrat de report 200, à savoir sa face supérieure dans l'orientation des figures 3A et 3B, en utilisant le substrat de support temporaire 140 comme poignée (figure 3A).

Les bornes de connexion 131 de puces élémentaires 153, situées du côté de la face inférieure desdites puces, sont alors mises en contact avec les plages de connexion correspondantes P1, P2, P3, P4, P5, P6 du substrat de report 200, et fixées auxdites plages de connexion P1, P2, P3, P4, P5, P6. La fixation des bornes de connexion 131 des puces élémentaires 153 aux plages de connexion du substrat de report est par exemple réalisée par collage direct, par thermocompression, par brasure, au moyen de microstructures métalliques (par exemple des micro-piliers) préalablement formées sur les bornes 131, ou par toute autre méthode de fixation et de connexion adaptée.

Une fois fixées, par leurs bornes de connexion 131, au substrat de report 200, les puces élémentaires 153 sont détachées du substrat de support temporaire 140 et ce dernier est retiré (figure 3B), libérant l'accès à la face d'émission des LED 123 (non détaillées sur les figures 3A à 3E).

Le pas des puces élémentaires 153 sur le substrat de report 200 peut être supérieur au pas des micropuces élémentaires 153 sur le substrat de support temporaire 140. De préférence, le pas des puces élémentaires 153 sur le substrat de report 200 est un multiple du pas des micropuces élémentaires 153 sur le substrat de support temporaire 140. Dans ce cas, seule une partie des puces 153 est prélevée sur le substrat de support 140 à chaque transfert, comme illustré sur les figures 3A et 3B. Les autres puces 153 restent solidaires du substrat de support temporaire 140 et peuvent être utilisées lors d'une autre étape de report collectif pour peupler une autre partie du substrat de report 200 ou un autre substrat de report.

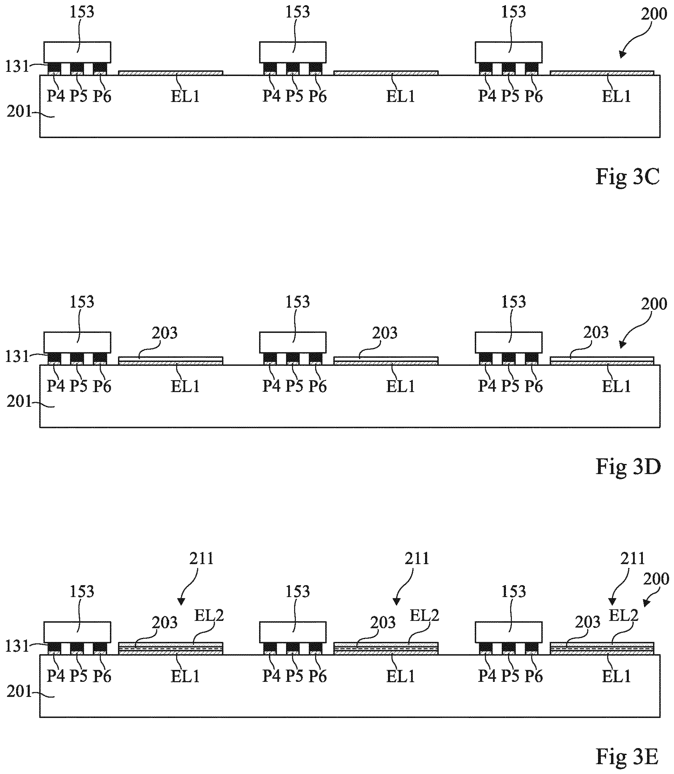

La figure 3C illustre le dispositif après fixation de l'ensemble des puces élémentaires 153 sur le substrat de report 200.

La figure 3D illustre une étape ultérieure de dépôt, dans chaque pixel, d'une portion de couche organique photosensible 203, par exemple sensible dans l'infrarouge ou dans le proche infrarouge, sur et en contact avec la face supérieure de l'électrode EL1 du pixel. Les portions de couche 203 sont par exemple déposées par un procédé d'impression localisée, par exemple par sérigraphie ou par un procédé de revêtement par filière à fente ("slot-die coating" en anglais). Dans chaque pixel, la portion de couche organique 203 s'étend par exemple sur toute la surface supérieure de l'électrode EL1 du pixel.

La figure 3E illustre une étape de dépôt, dans chaque pixel, d'une électrode supérieure EL2 sur et en contact avec la face supérieure de la portion de couche organique photosensible 203 du pixel. L'électrode EL2 s'étend par exemple sur toute la surface supérieure de la portion de couche organique photosensible 203 du pixel. L'électrode EL2 est transparente aux longueurs d'onde de sensibilité de la couche 203. A titre d'exemple, l'électrode EL2 est en un oxyde conducteur transparent, par exemple en ITO. Dans cet exemple, dans chaque pixel, l'empilement des couches EL1, 203 et EL2 forme un photodétecteur 211. Les électrodes EL1 et EL2 correspondent par exemple respectivement à l'électrode de cathode et à l'électrode d'anode du dispositif.

Les électrodes EL2 peuvent être déposées de façon localisée à travers un pochoir. A titre d'exemple, l'électrode supérieure EL2 est commune à tous les pixels du dispositif. L'électrode EL2 forme par exemple, en vue de dessus, une grille continue recouvrant les portions de couche photosensible 203 de tous les pixels du dispositif. L'électrode commune EL2 peut alors être connectée à un noeud d'application d'un potentiel de polarisation fixe VA en périphérie de la matrice de pixels.

Après le dépôt de l'électrode EL2, une couche isolante transparente de protection, non représentée, peut éventuellement être déposée sur toute la face supérieure de la structure par une méthode de dépôt conforme, afin notamment d'encapsuler la couche organique 203 et les LED des puces élémentaires 153 des pixels. La couche de protection est par exemple en alumine (Al₂O₃) ou en oxyde de silicium.

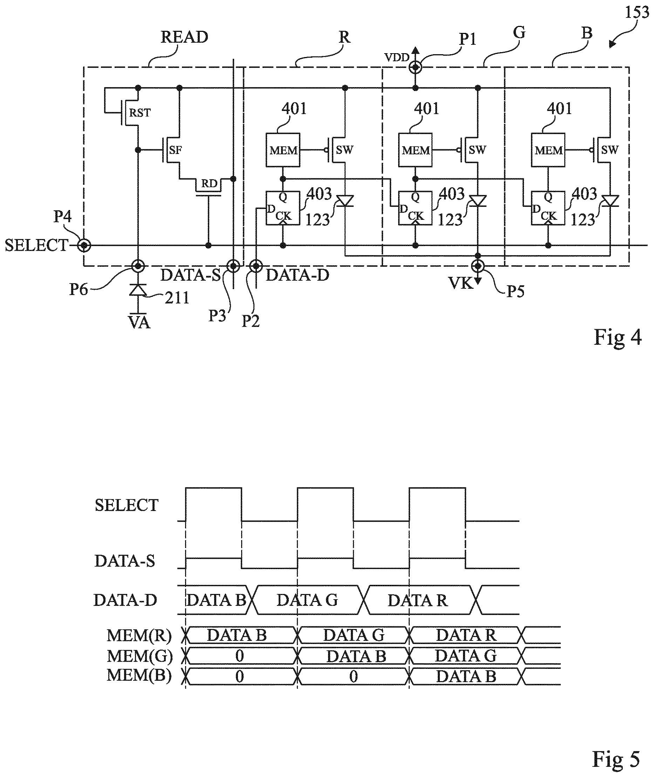

La figure 4 est un schéma électrique des circuits d'un exemple d'une puce élémentaire de pixel 153 d'un dispositif d'affichage interactif du type décrit ci-dessus.

Dans cet exemple, la puce 153 est une puce à 6 bornes ou plots de connexion 131 connectés respectivement aux six plages de connexion P1, P2, P3, P4, P5 et P6 du substrat de support 200 de la figure 2.

La puce 153 de la figure 4 comprend trois sous-pixels d'affichage R, G et B adaptés à émettre dans trois gammes de longueurs d'onde différentes, par exemple adaptés à émettre respectivement de la lumière rouge, de la lumière verte et de la lumière bleue. La puce 153 comprend en outre un circuit READ de lecture d'un signal représentatif d'une intensité lumineuse reçue par le photodétecteur 211 du pixel.

Chacun des sous-pixels R, G et B comprend un transistor MOS SW ayant un premier noeud de conduction relié, par exemple connecté, à la borne P1 d'application du potentiel d'alimentation haut VDD, et un deuxième noeud de conduction relié, par exemple connecté, à l'anode de la LED 123 du sous-pixel. Dans cet exemple, les transistors SW sont des transistors MOS à canal P, chaque transistor SW ayant sa source reliée, par exemple connectée, à la borne P1 et son drain relié, par exemple connecté, à l'anode de la LED 123 du sous-pixel.

Dans chacun des sous-pixels R, G et B, la LED 123 du sous-pixel a sa cathode reliée, par exemple connectée, à la borne P5 d'application du potentiel d'alimentation bas VK.

Dans cet exemple, les LED 123 sont commandées au moyen de signaux de consigne numériques à codage binaire, par exemple selon un procédé de commande de type PWM (de l'anglais "Pulse Width Modulation" - modulation en largeur d'impulsion), par exemple du type décrit dans la demande de brevet EP3079142 précédemment déposée par le demandeur. Chacun des sous-pixel R, G et B comprend un circuit mémoire 401 (MEM), par exemple une mémoire SRAM (de l'anglais "Statique Random Access Memory" - mémoire statique à accès aléatoire) ou une bascule de type D, adapté à mémoriser une suite de valeurs binaires (0 ou 1) définissant respectivement un état bloqué ou passant du transistor SW, et donc un état éteint ou allumé de la LED 123 du sous-pixel. A titre de variante, le circuit mémoire 401 peut comprendre un simple interrupteur et une capacité à faible fuite. Chaque circuit mémoire comprend un noeud de sortie relié, par exemple connecté, à un noeud de commande (grille) du transistor SW. Dans cet exemple, chacun des sous-pixels R, G et B comprend en outre une bascule D 403 ayant un noeud d'entrée de données D, un noeud de sortie de données Q relié, par exemple connecté, à un noeud d'entrée du circuit mémoire 401 du sous-pixel, et un noeud de commande CK relié, par exemple connecté, à la borne P4 d'application du signal de commande SELECT. Dans cet exemple, les bascules 403 des différents sous-pixels de la puce sont reliées en série. Plus particulièrement, dans l'exemple représenté, la bascule 403 du sous-pixel R a son noeud d'entrée de données D relié, par exemple connecté, à la borne P2 d'application du signal de données d'émission DATA_D, la bascule 403 du sous-pixel G a son noeud d'entrée de données D relié, par exemple connecté, au noeud Q de sortie de la bascule 403 du sous-pixel R, et la bascule 403 du sous-pixel B a son noeud d'entrée de données D relié, par exemple connecté, au noeud Q de sortie de la bascule 403 du sous-pixel G.

Dans cet exemple, le circuit READ de lecture du photodétecteur 211 comprend trois transistors MOS à canal N RST, SF et RD. Le transistor RST a son drain relié, par exemple connecté, à la borne P1 d'application du potentiel d'alimentation haut VDD et sa source reliée, par exemple connectée, à la borne P6 de cathode du photodétecteur 211 (électrode EL1 dans l'exemple des figures 2 et 3A à 3E). Dans cet exemple, la grille du transistor RST est connectée au drain de ce même transistor. Le transistor SF a son drain relié, par exemple connecté, à la borne P1 et sa source reliée, par exemple connectée, au drain du transistor RD. Le transistor SF a sa grille reliée, par exemple connectée, à la source du transistor RST. Le transistor RD a sa source reliée, par exemple connectée, à la borne P3 de fourniture du signal de sortie DATA_S du photodétecteur. La grille du transistor RD est reliée, par exemple connectée, à la borne P4 d'application du signal de commande SELECT.

La figure 5 est un diagramme illustrant de façon schématique le fonctionnement de la puce élémentaire de pixel 153 de la figure 4. La figure 5 représente plus particulièrement l'évolution, en fonction du temps, des signaux SELECT, DATA_S, DATA_D, et des signaux MEM(R), MEM(G) et MEM(B) contenus respectivement dans les mémoires MEM des sous-pixels R, G et B.

Dans cet exemple, des signaux de consigne d'émission respectifs DATA R, DATA G et DATA B des LED 123 des sous-pixels R, G et B sont des signaux numériques multiplexés temporellement sur la borne P2 (signal DATA_D). A chaque front montant du signal SELECT, un bit de donnée d'émission du signal DATA_D est transmis de la borne P2 à la mémoire 401 du sous-pixel R, le bit de données d'émission précédent est transmis de la borne de sortie Q de la bascule D 403 du sous-pixel R à la mémoire 401 du sous-pixel G, et le bit de données d'émission précédent est transmis de la borne de sortie Q de la bascule D 403 du sous-pixel G à la mémoire 401 du sous-pixel B. Ainsi, trois périodes du signal SELECT sont nécessaires pour transmettre trois signaux de consigne respectivement aux trois sous-pixels R, G et B du dispositif d'affichage.

La configuration en diode du transistor RST fonctionnant en régime de faible inversion implique une réponse logarithmique de la tension sur sa source en fonction du courant qui traverse son canal, dans ce cas le photocourant généré par la photodiode 211. Ainsi, le circuit de lecture READ met en oeuvre une lecture logarithmique du photo-courant généré par le photodétecteur 211. A chaque période d'activation du signal SELECT, le transistor RD du circuit de lecture READ est rendu passant. Le signal DATA_S fourni sur la borne de sortie P3 est alors une tension analogique représentative de la luminosité instantanée reçue par le photodétecteur 211 du pixel. Le signal DATA_S peut être lu et numérisé en pied de colonne. A titre d'exemple, à chaque mise à jour des signaux de consigne d'émission des sous-pixels R, G et B de la puce, le signal DATA_S du pixel peut être lu successivement trois fois et une moyenne des trois valeurs peut être réalisée, de façon à minimiser le bruit de lecture.

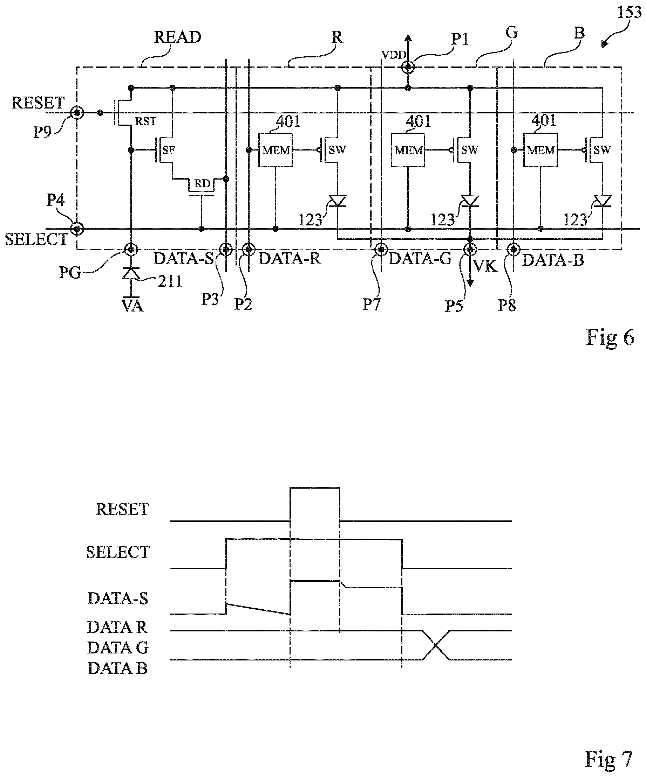

La figure 6 est un schéma électrique des circuits d'un autre exemple d'une puce élémentaire de pixel 153 d'un dispositif d'affichage interactif du type décrit ci-dessus.

Dans cet exemple, la puce élémentaire 153 comprend neuf plots de connexion 131 distincts destinés à être connectés respectivement à neuf plages métalliques de connexion distinctes P1, P2, P3, P4, P5, P6, P7, P8 et P9.

Les interconnexions des bornes P1, P2, P3, P4 et P5 des différents pixels en lignes et en colonnes sont identiques ou similaires à ce qui a été décrit précédemment. Comme dans l'exemple précédent, la borne P6 est connectée à l'électrode inférieure (cathode) du photodétecteur 211 du pixel. Dans cet exemple, les bornes P7 des pixels d'une même colonne sont interconnectées via une même piste conductrice de colonne, par exemple formée dans le niveau M1 du substrat de report. De façon similaire, les bornes P8 des pixels d'une même colonne sont interconnectées via une même piste conductrice de colonne, par exemple formée dans le niveau M1 du substrat de report. De plus, dans cet exemple, les bornes P9 des pixels d'une même ligne son interconnectées via une même piste conductrice de ligne, par exemple formée dans le niveau M2 du substrat de report. La personne du métier saura adapter en conséquence la réalisation du substrat de report 200 du dispositif.

Comme dans l'exemple de la figure 4, la puce 153 de la figure 6 comprend trois sous-pixels d'affichage R, G et B adaptés à émettre dans trois gammes de longueurs d'onde différentes, par exemple adaptés à émettre respectivement de la lumière rouge, de la lumière verte et de la lumière bleue. La puce 153 comprend en outre un circuit READ de lecture d'un signal représentatif d'une intensité lumineuse reçue par le photodétecteur 211 du pixel.

La puce 153 de la figure 6 diffère de la puce 153 de la figure 4 en ce que, dans l'exemple de la figure 6, les signaux de consigne d'émission DATA R, DATA G et DATA B des différents sous-pixels R, G et B ne sont pas multiplexés temporellement sur une même borne d'entrée de données de la puce, mais sont appliqués en parallèle respectivement sur les bornes P2, P7 et P8.

Ainsi, dans l'exemple de la figure 6, les bascules 403 des sous-pixels de la puces 153 de la figure 4 sont omises. Dans chacun des sous-pixels R, G et B, le circuit mémoire 401 a un noeud d'entrée de données relié, par exemple connecté, à la borne d'entrée de données P2, respectivement P7, respectivement P8 du sous-pixel, et un noeud de commande relié, par exemple connecté, à la borne P4 d'application du signal de commande SELECT.

La puce 153 de la figure 6 diffère en outre de la puce 153 de la figure 4 en ce que, dans l'exemple de la figure 6, la grille du transistor de réinitialisation RST du circuit de lecture READ n'est pas reliée au drain du transistor RST, mais est connectée à la borne P9, sur laquelle est appliquée un signal de commande de réinitialisation RESET.

La figure 7 est un diagramme illustrant de façon schématique le fonctionnement de la puce élémentaire de pixel 153 de la figure 6. La figure 7 représente plus particulièrement l'évolution, en fonction du temps, des signaux RESET, SELECT, DATA_S, DATA R, DATA G et DATA B.

Dans cet exemple, le signal RESET permet de commander le transistor de réinitialisation RST du circuit de lecture READ du photodétecteur 211. Ceci permet, à chaque lecture, d'échantillonner une première valeur du signal DATA_S à la fin d'une période d'intégration pendant laquelle le transistor de réinitialisation RST est maintenu bloqué, puis une deuxième valeur du signal DATA_S immédiatement après une période de réinitialisation du photodétecteur 211 pendant laquelle le transistor de réinitialisation RST est maintenu passant (la fin de la période de réinitialisation marquant le début d'une deuxième période d'intégration). La différence entre les deux valeurs lues définit la valeur de sortie du pixel. On réalise ainsi une lecture à échantillonnage double.

Les modes de réalisation décrits ne se limitent pas aux exemples de circuits électroniques de contrôle décrits en relation avec les figures 4 à 7. A titre de variante, dans l'exemple de de la figure 6, la borne P9 peut être omise et la grille du transistor de réinitialisation RST connectée au drain de ce même transistor RST. On obtient alors une puce à 8 bornes présentant, pour la partie photodétecteur, un fonctionnement similaire à celui de la puce de la figure 4.

Dans une autre variante, dans l'exemple de la figure 4, la grille du transistor de réinitialisation RST peut être connectée non pas au drain de ce même transistor, mais à une borne extérieure, non représentée, destinée à recevoir un signal de commande de réinitialisation. On obtient alors une puce à 7 bornes présentant, pour la partie photodétecteur, un fonctionnement similaire à celui de la puce de la figure 6.

Dans une autre variante, dans l'exemple de la figure 4, une bascule D additionnelle peut être ajoutée au circuit de lecture READ du photodétecteur 211. Ceci permet de commander le transistor de réinitialisation RST selon le même principe de décalage que les LED 123 des sous-pixels R, G et B. Un quatrième bit de commande est alors introduit dans le signal DATA_D pour piloter le transistor RST. A titre d'exemple, le transistor RST est commandé à l'état passant après les trois lectures successives du signal DATA_S (figure 5). Dans ce cas, le circuit de lecture READ est de préférence situé du côté droit du circuit, c'est-à-dire que la bascule additionnelle du circuit READ a un noeud d'entrée connecté au noeud de sortie Q de la bascule 403 du sous-pixel B, un noeud de sortie connecté à la grille du transistor RST, et un noeud de commande connecté à la borne P4 d'application du signal SELECT.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples particuliers de réalisation des puces élémentaires de pixel et du substrat de report décrits en relation avec les figures 1A à 1J, 2 et 3A à 3E.

En outre, les modes de réalisation décrits ne se limitent pas aux exemples particuliers de réalisation des circuits électroniques de contrôle des puces élémentaires de pixel décrits en relation avec les figures 4 à 7.

De plus, les modes de réalisation décrits ne se limitent pas au cas particulier décrit ci-dessus dans lequel les photodétecteurs du dispositif sont des photodiodes organiques. A titre de variante, les photodétecteurs organiques du dispositif décrit peuvent être remplacés par des photodétecteurs inorganiques, par exemple à base de matériaux semiconducteurs de type III-V, par exemple à base d'arséniure d'indium-gallium, ou à base de silicium amorphe. Dans une autre variante, les photodétecteurs 211 peuvent être constitués d'une couche matrice, par exemple en résine, dans laquelle sont incorporées des boîtes quantiques ("quantum dots" en anglais).

Plus généralement, les photodétecteurs peuvent être remplacés, tous ou en partie, par tout autre élément de capture ou d'actuation. Ces éléments de capture ou d'actuation peuvent être de tout type. Un exemple non limitatif de tels éléments peut être, par exemple, des transducteurs ultrasonores ou acoustiques, par exemple de type piézoélectrique. Ceci permet par exemple de mettre en oeuvre des fonctions de détection de toucher ou de proximité d'un objet, par exemple la main d'un utilisateur, par exemple en utilisant l'effet piézoélectrique direct, et/ou des fonctions de stimulation haptique, et/ou des fonctions d'émission d'ondes acoustiques directives, par exemple en utilisant l'effet piézoélectrique indirect.

Ainsi, par fonction d'actuation, on entend, par exemple, l'actionnement d'actionneurs piézoélectriques afin de générer une onde ultrasonore ou un mode de vibration apte à provoquer un effet haptique sensible à l'utilisateur.

A titre d'exemple, tous ou une partie des photodétecteur peuvent être remplacés par des actionneurs piézoélectriques comprenant chacun un empilement :
- d'une électrode inférieure, par exemple métallique, par exemple en argent, en molybdène, en platine, en or ou en un alliage d'un ou plusieurs de ces matériaux,
- d'une couche d'un matériau piézoélectrique, par exemple du titano-zirconiate de plomb (PZT), du nitrure d'aluminium (AlN), ou tout autre matériau piézoélectrique, et
- d'une électrode supérieure, par exemple métallique, par exemple en argent, en molybdène, en platine, en ruthénium, en or, ou en un alliage d'un ou plusieurs de ces matériaux.

L'application d'un champ électrique entre l'électrode supérieure et l'électrode inférieure induit une déformation du matériau piézoélectrique. Suivant le signal envoyé, par exemple sinusoïdal à une fréquence définie comme étant la fréquence de travail dimensionnée, l'actionneur génère une onde ultrasonore ou un mode de vibration (par exemple type mode de flexion, ou un mode de Lamb antisymétrique), par exemple apte à générer un effet haptique. Cet effet peut résulter d'une variation du coefficient de friction, notamment si le mode de vibration généré est un mode de Lamb.

Les circuits électroniques de lecture des puces élémentaires 153 sont alors remplacés par des circuits électroniques de commande des éléments de capture ou d'actuation, par exemple des circuits de commande des transducteurs ultrasonores en émission et/ou en réception.

A titre d'exemple, dans le mode de réalisation de la figure 6, le signal RESET peut être remplacé par un signal de commande, par exemple pulsé ou sinusoïdal, servant à actionner l'élément de capture ou d'actuation, par exemple piézoélectrique, à la place de la photodiode lorsque le signal SELECT est actif.

A titre d'exemple, dans le procédé décrit ci-dessus en relation avec les figures 3A à 3E, la couche organique photosensible 201 est remplacée par une couche piézoélectrique ou ferroélectrique, par exemple en nitrure d'aluminium (AlN), en titano-zirconiate de plomb (PZT), ou en Oxyde de Zinc (ZnO). L'empilement comprenant l'électrode inférieure EL1, la couche piézoélectrique et l'électrode supérieure EL2 peut être déposé directement sur le substrat 201, ou fabriqué séparément et reporté sur le substrat 201. Chacune des électrodes EL1 et EL2 peut être en métal ou en un oxyde conducteur transparent.

En variante, les éléments de capture ou d'actuation peuvent être disposés sur le substrat 201 avant l'étape de report des puces élémentaires 153.

L'invention est définie par les revendications annexées.

## Revendications

1. Dispositif comportant :
- un substrat de report (200) comportant des éléments de connexion électrique ; et
- une pluralité de puces élémentaires monolithiques discrètes (153) fixées et connectées électriquement au substrat de report (200), chaque puce élémentaire (153) comportant au moins une LED (123) et un circuit électronique de contrôle, le circuit électronique de contrôle comprenant une pluralité de transistors, le circuit électronique de contrôle comprenant un circuit de commande de ladite au moins une LED (123),
le dispositif comportant en outre, associé à au moins une puce élémentaire (153), un élément (211) de capture ou d'actuation externe à la puce élémentaire (153), fixé et connecté électriquement au substrat de report (200), dans lequel, dans chaque puce élémentaire (153), le circuit électronique de contrôle comprend en outre un circuit électronique (READ) de lecture ou de commande de l'élément (211) de capture ou d'actuation associé à la puce.

2. Dispositif selon la revendication 1, dans lequel chaque élément (211) de capture et d'actuation est un photodétecteur.

3. Dispositif selon la revendication 2, dans lequel chaque photodétecteur (211) comprend une couche organique photosensible.

4. Dispositif selon l'une quelconque des revendications 1 à 3, dans lequel, dans chaque puce élémentaire (153), ladite au moins une LED (123) est une LED inorganique.

5. Dispositif selon la revendication 4, dans lequel, dans chaque puce élémentaire (153), ladite au moins une LED (123) est une LED au nitrure de gallium.

6. Dispositif selon l'une quelconque des revendications 1 à 5, dans lequel chaque puce élémentaire (153) comprend une pluralité de sous-pixels (R, G, B) comprenant chacun une LED (123) et un circuit de commande de la LED (123).

7. Dispositif selon la revendication 6, dans lequel, dans chaque puce élémentaire (153), les circuits de commande des LED (123) des différents sous-pixels (R, G, B) de la puce sont connectés à une même borne d'entrée (131) de la puce, connectée à une plage de connexion correspondante (P2) du substrat de report (200), destinée à recevoir séquentiellement des signaux de consigne d'émission (DATA R, DATA G, DATA B) des différents sous-pixels (R, G, B) de la puce.

8. Dispositif selon la revendication 6, dans lequel, dans chaque puce élémentaire (153), les circuits de commande des LED (123) des différents sous-pixels (R, G, B) de la puce sont connectés respectivement à différentes bornes d'entrée (131) de la puce, connectées respectivement à différentes plages de connexion correspondantes (P2, P7, P8) du substrat de report (200), destinées à recevoir en parallèle des signaux de consigne d'émission (DATA R, DATA G, DATA B) des différents sous-pixels (R, G, B) de la puce.

9. Dispositif selon l'une quelconque des revendications 1 à 8, dans lequel, dans chaque puce élémentaire (153), le circuit de commande de ladite au moins une LED (123) est configuré pour commander ladite au moins une LED au moyen de signaux de consigne numériques à codage binaire.

10. Dispositif selon la revendication 2, dans lequel, dans chaque puce élémentaire (153), le circuit de lecture (READ) du photodétecteur (211) associé à la puce est connecté à une borne de sortie (P3) de la puce, connectée à une plage de connexion correspondante (P3) du substrat de report (200), destinée à fournir un signal (DATA_S) représentatif d'une intensité lumineuse reçue par le photodétecteur (211).

11. Dispositif selon la revendication 1, dans lequel l'élément (211) de capture ou d'actuation est un transducteur piézoélectrique.

## Patentansprüche

1. Vorrichtung, aufweisend:
- ein Transfersubstrat (200), das elektrische Verbindungselemente aufweist, und
- eine Vielzahl diskreter monolithischer Elementar-Chips (153), die mit dem Transfersubstrat (200) gebondet und elektrisch verbunden sind, wobei jeder Elementar-Chip (153) mindestens eine LED (123) und eine elektronische Steuerschaltung aufweist, wobei die elektronische Steuerschaltung eine Vielzahl von Transistoren aufweist, wobei die elektronische Steuerschaltung eine Schaltung zum Steuern der mindestens einen LED (123) aufweist, wobei die Vorrichtung ferner ein mit mindestens einem Elementarchip (153) assoziiertes Erfassungs- oder Betätigungselement (211) außerhalb des Elementarchips (153) aufweist, das mit dem Transfersubstrat (200) gebondet und elektrisch verbunden ist, wobei in jedem Elementarchip (153) die elektronische Steuerschaltung ferner eine elektronische Schaltung (READ) zum Lesen von oder Steuern des mit dem Chip assoziierten Erfassungs- oder Betätigungselements (211) aufweist.

2. Vorrichtung gemäß Anspruch 1, wobei jedes Erfassungs- und Betätigungselement (211) ein Fotodetektor ist.

3. Vorrichtung gemäß Anspruch 2, wobei jeder Fotodetektor (211) eine lichtempfindliche organische Schicht aufweist.

4. Vorrichtung gemäß einem der Ansprüche 1 bis 3, wobei in jedem Elementarchip (153) die mindestens eine LED (123) eine anorganische LED ist.

5. Vorrichtung gemäß Anspruch 4, wobei in jedem Elementarchip (153) die mindestens eine LED (123) eine Galliumnitrid-LED ist.

6. Vorrichtung gemäß einem der Ansprüche 1 bis 5, wobei jeder Elementarchip (153) eine Vielzahl von Subpixeln (R, G, B) aufweist, die jeweils eine LED (123) und eine Schaltung zum Steuern der LED (123) ausweisen.

7. Vorrichtung gemäß Anspruch 6, wobei in jedem Elementarchip (153) die Schaltungen zum Steuern der LEDs (123) der verschiedenen Subpixel (R, G, B) des Chips mit einem gleichen Eingangsanschluss (131) des Chips verbunden sind, der mit einem entsprechenden Verbindungsbereich (P2) des Transfersubstrats (200) verbunden ist, der dazu bestimmt ist, sequentiell Emissionssollwertsignale (DATA R, DATA G, DATA B) für die verschiedenen Subpixel (R, G, B) des Chips zu empfangen.

8. Vorrichtung gemäß Anspruch 6, wobei in jedem Elementarchip (153) die Schaltungen zum Steuern der LEDs (123) der verschiedenen Subpixel (R, G, B) des Chips jeweils mit verschiedenen Eingangsanschlüssen (131) des Chips verbunden sind, die jeweils mit verschiedenen entsprechenden Verbindungsbereichen (P2, P7, P8) des Transfersubstrats (200) verbunden sind, die dazu bestimmt sind, parallel Emissionssollwertsignale (DATA R, DATA G, DATA B) für die verschiedenen Subpixel (R, G, B) des Chips zu empfangen.

9. Vorrichtung gemäß einem der Ansprüche 1 bis 8, wobei in jedem Elementarchip (153) die Schaltung zum Steuern der mindestens einen LED (123) konfiguriert ist zum Steuern der mindestens einen LED mittels binär codierter digitaler Sollwertsignale.

10. Vorrichtung gemäß Anspruch 2, wobei in jedem Elementarchip (153) die Schaltung (READ) zum Lesen von dem mit dem Chip assoziierten Fotodetektor (211) mit einem Ausgangsanschluss (P3) des Chips verbunden ist, der mit einem entsprechenden Verbindungsbereich (P3) des Transfersubstrats (200) verbunden ist, der dazu bestimmt ist, ein Signal (DATA_S) zu liefern, das für eine von dem Fotodetektor (211) empfangene Lichtintensität repräsentativ ist.

11. Vorrichtung gemäß Anspruch 1, wobei das Erfassungs- oder Betätigungselement (211) ein piezoelektrischer Wandler ist.

## Claims

1. Device comprising:
- a transfer substrate (200) comprising electric connection elements; and
- a plurality of discrete monolithic elementary chips (153) bonded and electrically connected to the transfer substrate (200), each elementary chip (153) comprising at least one LED (123) and an electronic control circuit, the electronic control circuit comprising a plurality of transistors, the electronic control circuit comprising a circuit for controlling said at least one LED (123),
the device further comprising, associated with at least one elementary chip (153), a capture or actuation element (211) external to the elementary chip (153), bonded and electrically connected to the transfer substrate (200), wherein, in each elementary chip (153), the electronic control circuit further comprises an electronic circuit (READ) for reading from or controlling the capture or actuation element (211) associated with the chip.

2. Device according to claim 1, wherein each capture and actuation element (211) is a photodetector.

3. Device according to claim 2, wherein each photodetector (211) comprises a photosensitive organic layer.

4. Device according to any of claims 1 to 3, wherein, in each elementary chip (153), said at least one LED (123) is an inorganic LED.

5. Device according to claim 4, wherein, in each elementary chip (153), said at least one LED (123) is a gallium nitride LED.

6. Device according to any of claims 1 to 5, wherein each elementary chip (153) comprises a plurality of sub-pixels (R, G, B), each comprising a LED (123) and a circuit for controlling the LED (123).

7. Device according to claim 6, wherein, in each elementary chip (153), the circuits for controlling the LEDs (123) of the different sub-pixels (R, G, B) of the chip are connected to a same input terminal (131) of the chip, connected to a corresponding connection area (P2) of the transfer substrate (200), intended to sequentially receive emission set point signals (DATA R, DATA G, DATA B) for the different sub-pixels (R, G, B) of the chip.

8. Device according to claim 6, wherein, in each elementary chip (153), the circuits for controlling the LEDs (123) of the different sub-pixels (R, G, B) of the chip are respectively connected to different input terminals (131) of the chip, respectively connected to different corresponding connection areas (P2, P7, P8) of the transfer substrate (200), intended to receive in parallel emission set point signals (DATA R, DATA G, DATA B) for the different sub-pixels (R, G, B) of the chip.

9. Device according to any of claims 1 to 8, wherein, in each elementary chip (153), the circuit for controlling said at least one LED (123) is configured to control said at least one LED by means of binary-coded digital set point signals.

10. Device according to claim 2, wherein, in each elementary chip (153), the circuit (READ) for reading from the photodetector (211) associated with the chip is connected to an output terminal (P3) of the chip, connected to a corresponding connection area (P3) of the transfer substrate (200), intended to deliver a signal (DATA_S) representative of a light intensity received by the photodetector (211).

11. Device according to claim 1, wherein the capture or actuation element (211) is a piezoelectric transducer.
